# EUROPEAN PATENT APPLICATION

(11) **EP 4 421 219 A1**
(43) Date of publication of application: **28.08.2024**
(21) Application number: 21961389.0
(22) Date of filing: 20.10.2021
(51) Int. Cl.: C30B 29/36, H01L 21/20

(54) **SIC SINGLE CRYSTAL SUBSTRATE AND PRODUCTION METHOD THEREFOR**

(71) Applicant: NGK Insulators, Ltd., Nagoya city, Aichi 467-8530 (JP)
(72) Inventor: NOZAKI, Fumiyasu, Nagoya-City, Aichi 467-8530 (JP); MATSUSHIMA, Kiyoshi, Nagoya-City, Aichi 467-8530 (JP); YOSHIKAWA, Jun, Nagoya-City, Aichi 467-8530 (JP)
(74) Representative: Müller-Boré & Partner Patentanwälte PartG mbB
(86) International application number: PCT/JP2021/038798
(87) International publication number: WO 2023/067736

(57) **Abstract**

Provided is a method for producing SiC single crystal substrate having a low basal plane dislocation density and a small amount of warpage. The production method includes the steps of placing a SiC single crystal serving as a seed crystal and a SiC powder layer in a container in a state in which the SiC single crystal and the SiC powder layer are in contact with each other and performing a heat treatment by placing the container in an effective working zone of a firing furnace controlled to a temperature range within ±50°C of a preset temperature to grow a SiC single crystal on the seed crystal.

## Description

### TECHNICAL FIELD

The present invention relates to a SiC single crystal substrate and a production method therefor.

### BACKGROUND ART

SiC (silicon carbide) is attracting attention as a wide bandgap material that can control high voltage and high power with low loss. Particularly in recent years, there has been an expectation that power semiconductor devices using SiC materials (SiC power devices) will be used in a variety of applications due to their smaller size, lower power consumption, and higher efficiency than devices using Si semiconductors. For example, by adopting a SiC power device, converters, inverters, on-board chargers, and the like for electric vehicles (EVs) and plug-in hybrid vehicles (PHEVs) can be made smaller and more efficient.

Meanwhile, when using a SiC power device in high-voltage applications, in order to handle the large current, it is desirable to reduce defects in the SiC wafer as much as possible, especially basal plane dislocations known as a device killer defect, and to suppress deterioration of the device properties. Commercially available SiC wafers are generally produced by sublimation method, but methods such as the RAF (Repeated A-Face) method and the solution growth method are known as methods that further reduce defects within the wafer. However, in the RAF method, it is difficult to increase the diameter and costs are high, and the solution growth method has problems such as the tendency of inclusions to form in the crystal.

As another example of a production method for reducing defects, Patent Literature 1 (JP3248071B) discloses that a SiC single crystal with few micropipes can be obtained by heat treating a composite in which a SiC polycrystalline body is provided on a SiC single crystal, the SiC polycrystalline body is transformed into a solid phase. Further, Patent Literature 2 (JP4069508B) discloses a method for producing a SiC single crystal with closed micropipes, characterized by embedding the SiC single crystal in SiC powder and heat-treating.

### CITATION LIST

### PATENT LITERATURE

Patent Literature 1: JP3248071B
Patent Literature 2: JP4069508B

### SUMMARY OF INVENTION

As described above, although various methods for reducing defects (dislocations) in SiC single crystal substrates have been studied, further improvements are required. For example, the production method disclosed in Patent Literature 1 does not deal with the reduction of defects other than micropipes, and also has the problem that warpage tends to occur in the substrate. Further, although Patent Literature 2 addresses the reduction of micropipes, there is a problem in that dislocations other than micropipes cannot be reduced. Therefore, it is desired to reduce defects in SiC wafers, especially basal plane dislocations known as a device killer defect.

The present inventors have newly discovered that it is possible to produce a SiC single crystal substrate having a low basal plane dislocation density and a small amount of warpage by heat-treating a SiC single crystal as a seed crystal and a SiC powder layer in a state where the SiC single crystal and the SiC powder layer are in contact with each other and a temperature gradient is small.

Therefore, it is an object of the present invention to provide a SiC single crystal substrate having a low basal plane dislocation density and a small amount of warpage, and a production method therefor.

According to an aspect of the present invention, there is provided a method for producing a SiC single crystal substrate comprising the steps of:
placing a SiC single crystal serving as a seed crystal and a SiC powder layer in a container in a state in which the SiC single crystal and the SiC powder layer are in contact with each other; and
performing a heat treatment by placing the container in an effective working zone of a firing furnace controlled to a temperature range within ±50°C of a preset temperature to grow a SiC single crystal on the seed crystal.

According to another aspect of the present invention, there is provided a SiC single crystal substrate having a basal plane dislocation density of at least one surface of 0 to 1.0 × 10² cm⁻² and an amount of warpage of 0 to 40 µm, wherein
in a planar view figure of a surface of the SiC single crystal substrate, when two straight lines X and Y that are orthogonal to each other through a point G, which is the center of gravity of the planar view figure, are drawn, with two points A and B being defined to be each 45 mm away from the point G on the straight line X and two points C and D being defined to be each 45 mm away from the point G on the straight line Y,
the amount of warpage is defined by:
   (i) determining, among line segments extending perpendicularly to a line segment AB from any point on a curve AB between the point A and the point B on the surface of the SiC single crystal substrate, a point P on the curve AB where the distance of the line segment is the longest,
   (ii) taking a distance between the line segment AB and the point P to be an amount of warpage α,
   (iii) determining, among line segments extending perpendicularly to a line segment CD from any point on a curve CD between the point C and the point D on the surface of the SiC single crystal substrate, a point R on the curve CD where the distance of the line segment is the longest,
   (iv) taking a distance between the line segment CD and the point R to be an amount of warpage β, and
   (v) taking an arithmetic mean value of the amounts of warpage α and β to be the amount of warpage.

### BRIEF DESCRIPTION OF DRAWINGS

Figure 1 is a schematic cross-sectional view showing one mode of placement of a SiC powder layer and a seed crystal in a container.
Figure 2 is a schematic cross-sectional view showing another mode of placement of a SiC powder layer and a seed crystal in a container.
Figure 3 is a schematic cross-sectional view showing another mode of placement of a SiC powder layer and a seed crystal in a container.
Figure 4 is a schematic cross-sectional view showing another mode of placement of a SiC powder layer and a seed crystal in a container.
Figure 5 is a schematic cross-sectional view showing one mode of placement of a SiC powder layer, a seed crystal, and a dense body in a container.
Figure 6 is a schematic cross-sectional view showing another mode of placement of a SiC powder layer, a seed crystal, and a dense body in a container.
Figure 7 is a schematic cross-sectional view showing another mode of placement of a SiC powder layer, a seed crystal, and a dense body in a container.
Figure 8 is a schematic cross-sectional view showing another mode of placement of a SiC powder layer, a seed crystal, and a dense body in a container.
Figure 9 is a schematic cross-sectional view showing another mode of placement of a SiC powder layer, a seed crystal, and a dense body in a container.
Figure 10 is a top view of a SiC single crystal substrate 10 for illustrating a method for measuring the amount of warpage of the SiC single crystal substrate 10.
Figure 11 is a schematic cross-sectional view of the SiC single crystal substrate 10 for illustrating the method for measuring the amount of warpage of the SiC single crystal substrate 10.
Figure 12 is a schematic cross-sectional view of the SiC single crystal substrate 10 for illustrating the method for measuring the amount of warpage of the SiC single crystal substrate 10.

### DESCRIPTION OF EMBODIMENTS

### SiC single crystal substrate production method

The present invention relates to a method for producing a SiC single crystal substrate. In this production method, first, a SiC single crystal serving as a seed crystal and a SiC powder layer are placed in a container in a state in which the SiC single crystal and the SiC powder layer are in contact with each other. Next, a heat treatment is performed by placing the container in an effective working zone of a firing furnace controlled to a temperature range within ±50°C of a preset temperature to grow a SiC single crystal on the seed crystal. In this way, by heat-treating the SiC single crystal serving as a seed crystal and the SiC powder layer in a state in which the SiC single crystal and the SiC powder layer are in contact with each other and the temperature gradient is small, a SiC single crystal substrate having a low basal plane dislocation density and a small amount of warpage can be produced.

As described above, when using a SiC power device in high-voltage applications, in order to handle the large current, it is desirable to reduce defects in the SiC wafer as much as possible, especially basal plane dislocations, which are known as a device killer defect, and to suppress deterioration of the device properties. In addition, it is also desirable to suppress warping of the substrate. However, with conventional methods, it has been difficult to produce a SiC single crystal substrate having a low basal plane dislocation density and a small amount of warpage. In this regard, according to the present invention, such problem can be conveniently solved. Although the mechanism is not entirely clear, it is thought to be as follows. That is, in conventional production methods like that disclosed in Patent Literature 1, there was a problem in that warping occurs due to the difference in thermal expansion of the substrate, but in the production method of the present invention, the heat treatment is performed in a state in which the temperature gradient is small, so a difference in thermal expansion is less likely to occur, and thus it is thought that the substrate is less likely to warp. Moreover, in Patent Literature 2, because a new SiC single crystal is not grown on the SiC single crystal, dislocations other than micropipes cannot be reduced, but in the production method of the present invention, because a SiC single crystal is newly grown by performing the heat treatment out in a state in which the SiC single crystal serving as a seed crystal and the SiC powder layer are in contact with each other, dislocations other than micropipes (especially basal plane dislocation) can also be reduced.

As described above, the production method of the SiC single crystal substrate includes (1) placing a seed crystal and a SiC powder layer, and (2) performing a heat treatment to grow the SiC single crystal.

### (1) Placing of seed crystal and SiC powder layer

First, the SiC single crystal serving as a seed crystal and the SiC powder layer are placed in a container in a state in which the SiC single crystal and the SiC powder layer are in contact with each other. The seed crystal is typically composed of a SiC single crystal, and has a crystal growth surface. The polytype, off-angle, and polarity of the SiC single crystal are not particularly limited, but the polytype is preferably 4H, 6H, or 3C. Further, a SiC single crystal formed on a Si substrate may be used as the seed crystal. The crystal growth plane on the SiC single crystal serving as the seed crystal may be either the Si plane or the C plane, or may be both the Si plane and the C plane.

The SiC powder layer typically refers to a SiC powder spread in a layer inside the container. Further, this SiC powder layer is typically composed of a SiC powder. The SiC powder may be either α-SiC or β-SiC. There are no particular limitations on the particle size and purity of the SiC powder, and any commercially available powder can be used. However, in order to produce a highly pure SiC single crystal substrate, it is desirable that the SiC powder also be of a high purity. It is noted that the SiC powder layer may contain additives in addition to the SiC powder.

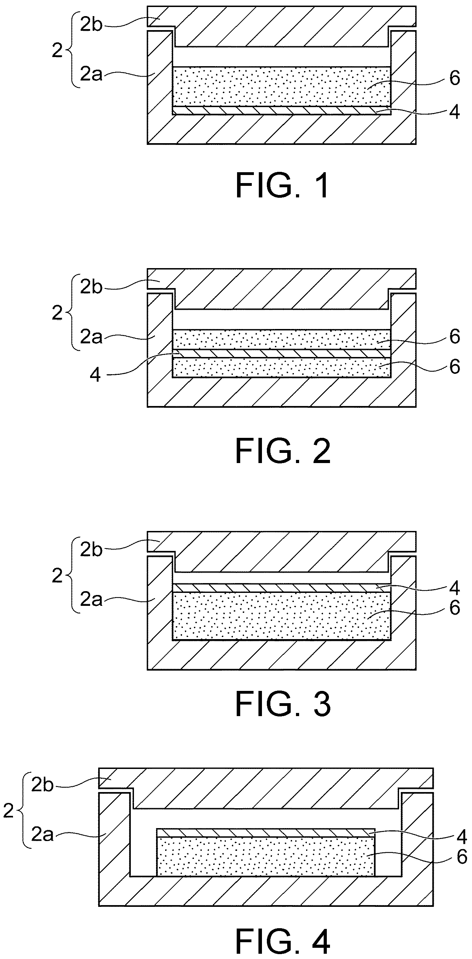

As shown in Figures 1 to 4, the position of a seed crystal 4 and a SiC powder layer 6 is not particularly limited as long as they are in contact with each other. That is, as shown in Figure 1, the seed crystal 4 may be placed on the inner bottom surface of a container 2, and the SiC powder layer 6 may be placed thereon, or as shown in Figure 2, the seed crystal 4 may be embedded in the SiC powder layer 6. Alternatively, as shown in Figure 3, the SiC powder layer 6 may be placed on the inner bottom surface of the container 2, and the seed crystal 4 may be placed on the top surface of the SiC powder layer 6. In any case, it is preferred that only one side of the seed crystal 4 be in contact with the SiC powder layer 6. Further, as long as the seed crystal 4 and the SiC powder layer 6 are in contact with each other, a plurality of seed crystals 4 may be placed in one container 2. In addition, as shown in Figure 4, as long as the seed crystal 4 and the SiC powder layer 6 are in contact with each other, a lateral space may be provided so that the side faces (outer circumferential edges) of the seed crystal 4 and the SiC powder layer 6 are not in contact with the inner wall of the container 2.

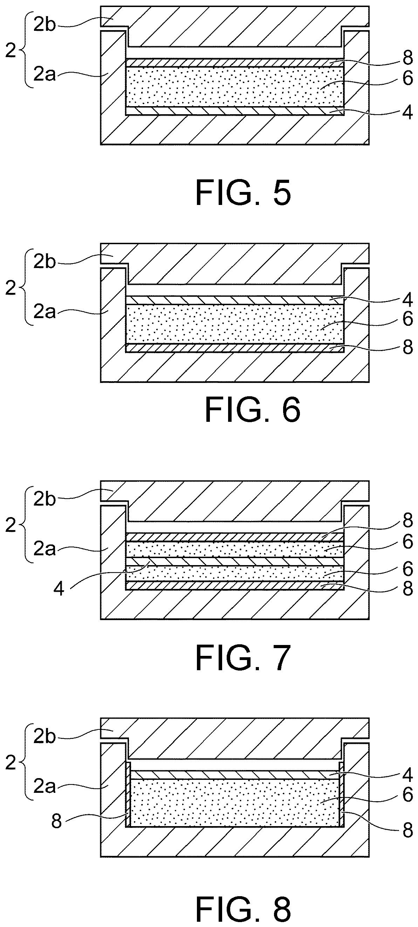

As shown in Figures 5 to 7, a dense body 8 may be placed on the bottom surface and/or top surface of the SiC powder layer 6 (excluding the surface in contact with the seed crystal 4). By placing the dense body 8 in this way, impurities can be prevented from entering from the inner bottom surface of the container 2 and/or a container lid 2b, and a higher purity SiC single crystal can be grown. For example, when the seed crystal 4 is not placed on the top surface of the SiC powder layer 6, the dense body 8 may be placed on the top surface of the SiC powder layer 6, as shown in Figure 5. When the seed crystal 4 is not placed on the inner bottom surface of the container 2, the dense body 8 may be placed between the SiC powder layer 6 and the inner bottom surface of the container 2, as shown in Figure 6. When the seed crystal 4 is embedded in the SiC powder layer 6, the dense body 8 may be placed on the top surface of the SiC powder layer 6 and/or between the SiC powder layer 6 and the inner bottom surface of the container 2, as shown in Figure 7.

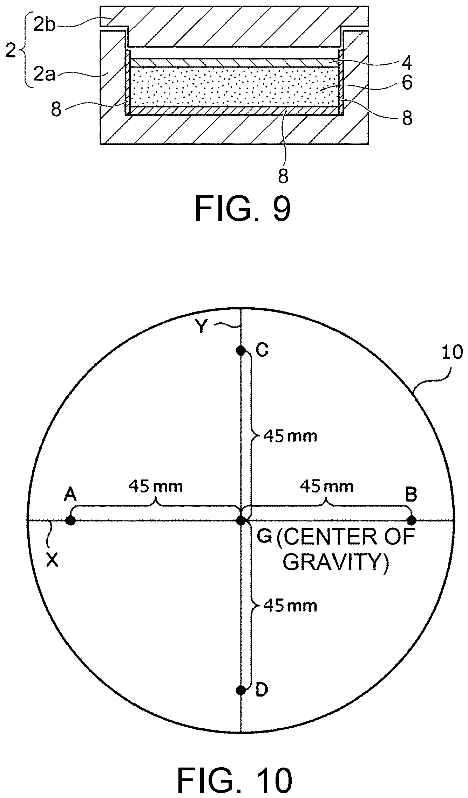

As shown in Figures 8 and 9, the dense body 8 may be placed at an outer circumferential edge of the SiC powder layer 6. By placing the dense body 8 in this manner, impurities can be prevented from entering from the side surface of the container 2, and a higher purity SiC single crystal can be grown. For example, as shown in Figure 8, the dense body 8 may be placed between an outer circumferential portion of the SiC powder layer 6 and the inner wall of the container 2. At this time, it is preferred that the dense body 8 be in contact with at least the outer peripheral portion of the SiC powder layer 6. In particular, as shown in Figure 9, it is preferred that the dense body 8 be placed on a bottom surface and/or top surface of the SiC powder layer 6 (excluding the surface in contact with the seed crystal 4), and that the dense body 8 be placed on an outer circumferential edge of the SiC powder layer 6.

The dense body 8 is preferably a solid having a relative density of 90% or more, more preferably 95% or more, and further preferably 99% or more. The higher the relative density, the more effectively the entry of impurities can be prevented. The relative density can be determined, for example, by multiplying the value obtained by dividing the actually measured bulk density of the dense body by the theoretical density of the dense body by 100 using the Archimedes method. The dense body 8 is not particularly limited as long as it does not sublimate or melt and does not react with SiC at the firing temperature during the heat treatment described below. Examples of the material of the dense body 8 include polycrystalline carbides such as TiC, TaC, NbC, and WC, and nitrides such as Si₃N₄ and TiN. Although the shape of the dense body 8 is not particularly limited, it is preferably layered.

The material of the container 2 is not particularly limited as long as it does not sublimate or melt at the firing temperature during the heat treatment described below, but a container made of graphite or SiC is desirable. Further, the inner and outer walls of the container 2 may be coated. Examples of the coating material include SiC, TiC, TaC, NbC, WC, and the like. Although the shape of the container 2 is not particularly limited, the container 2 preferably has an internal space capable of accommodating the seed crystal 4 and the SiC powder layer 6, and includes a container body 2a having an open top and a container lid 2b that fits into the open top portion of the container body 2a.

### (2) Heat treatment (growth of single crystal)

After (1) above, a heat treatment is performed by placing the container in the effective working zone of a firing furnace controlled to a temperature range within ±50°C of the preset temperature, thereby causing a SiC single crystal to grow on the seed crystal. In this manner, the heat treatment can be performed with a small temperature gradient. Here, "effective working zone" refers to "the charging region in a heat treatment apparatus in which a metal product can be maintained within the permissible temperature range depending on the purpose of heat treatment" as defined by JIS B 6905:1995. The temperature range of the effective working zone is within ±50°C of the preset temperature, preferably within ±20°C of the preset temperature, and further preferably within ±10°C of the preset temperature. In this way, when the temperature range is narrower, the heat treatment can be performed with a smaller temperature gradient, which enables a higher quality (that is, a lower dislocation density and a smaller amount of warpage) SiC single crystal to be grown.

The firing furnace used for the heat treatment is not particularly limited as long as crystal growth of SiC occurs on the seed crystal, and may be any known firing furnace such as a resistance furnace, an arc furnace, or an induction furnace. The atmosphere in the firing furnace during firing is preferably a vacuum, nitrogen, an inert gas, or a mixed atmosphere of nitrogen and an inert gas. Further, the heat treatment may be performed under normal pressure or under pressure such as hot press. The heat treatment temperature is preferably 1700 to 2700°C, more preferably 2000 to 2600°C, and further preferably 2200 to 2500°C. In addition, the holding time at the temperature within the above range is not particularly limited, and the longer the holding time is, the thicker the SiC single crystal can grow, so the holding time can be set according to the desired thickness.

### (3) Polishing

After the SiC single crystal is grown on the seed crystal in this way, it is preferred to polish the surface of the SiC single crystal. For example, the SiC single crystal substrate can be obtained by polishing using diamond abrasive grains and then finishing with chemical mechanical polishing (CMP).

### SiC single crystal substrate

With the production method described above, it is possible to produce a SiC single crystal substrate having a low basal plane dislocation density and a small amount of warpage. The basal plane dislocation density of at least one surface of the SiC single crystal substrate is preferably 0 to 1.0 × 10² cm⁻², more preferably 0 to 5.0 × 10¹ cm⁻², and further preferably 0 to 1.0 × 10¹ cm⁻². Further, the amount of warpage of the SiC single crystal substrate is preferably 0 to 40 µm, more preferably 0 to 30 µm, and further preferably 0 to 20 µm.

As used herein, "amount of warpage" is defined as follows as shown in Figures 10 to 12. In a planar view figure of a surface of the SiC single crystal substrate, when two straight lines X and Y that are orthogonal to each other through a point G, which is the center of gravity of the planar view figure, are drawn, with two points A and B being defined to be each 45 mm away from the point G on the straight line X and two points C and D being defined to be each 45 mm away from the point G on the straight line Y, the "amount of warpage" is defined by (i) determining, among line segments extending perpendicularly to a line segment AB from any point on a curve AB between the point A and the point B on the surface of the SiC single crystal substrate, a point P on the curve AB where the distance of the line segment is the longest, (ii) taking a distance between the line segment AB and the point P to be an amount of warpage α, (iii) determining, among line segments extending perpendicularly to a line segment CD from any point on a curve CD between the point C and the point D on the surface of the SiC single crystal substrate, a point R on the curve CD where the distance of the line segment is the longest, (iv) taking a distance between the line segment CD and the point R to be an amount of warpage β, and (v) taking an arithmetic mean value of the amounts of warpage α and β to be the "amount of warpage".

The SiC single crystal substrate is preferably oriented in the c-axis direction and the a-axis direction. The SiC single crystal substrate may be a SiC single crystal or a mosaic crystal as long as it is oriented in the two axis directions of the c-axis and the a-axis. A mosaic crystal is a collection of crystals that do not have clear grain boundaries but have slightly different crystal orientations in one or both of the c-axis and the a-axis. The method for evaluating the orientation is not particularly limited, and for example, a known analysis method such as an EBSD (Electron Back Scatter Diffraction Patterns) method or an X-ray pole figure can be used. For example, in the case of using the EBSD method, an inverse pole figure map of the surface (plate surface) of the SiC single crystal substrate or a cross section perpendicular to the plate surface is measured. In the obtained inverse pole figure map, the SiC single crystal substrate can be defined as being oriented in two axes, namely, a substantially normal direction and a substantially plate surface direction, when the following four conditions are satisfied: (A) the SiC single crystal substrate is oriented in a specific direction (first axis) substantially normal to the plate surface; (B) the SiC single crystal substrate is oriented in a specific direction (second axis) substantially in-plane to the plate surface and orthogonal to the first axis; (C) an inclination angle from the first axis is distributed within ±10°; and (D) an inclination angle from the second axis is distributed within ±10°. In other words, when the above four conditions are satisfied, it is determined that the SiC single crystal substrate is orientated in two axes, namely, the c-axis and the a-axis. For example, when the substantially normal direction of the plate surface is oriented to the c-axis, the substantially in-plane direction to the plate surface may be oriented in a specific direction (for example, an a-axis) that is orthogonal to the c-axis. The SiC single crystal substrate may be oriented in two axes, that is, the substantially normal direction and the substantially in-plane direction to the plate surface, but it is preferred that the substantially normal direction is oriented in the c-axis. The smaller the inclination angle distribution in the substantially normal direction and/or the substantially in-plane direction to the plate surface, the smaller the mosaic nature of the SiC single crystal substrate, and the closer the mosaic nature is to zero, the closer the crystal is to being a single crystal. Therefore, from the viewpoint of the crystallinity of the SiC single crystal substrate, the inclination angle distribution is preferably small in both the substantially normal direction and the substantially plate surface direction, for example, the inclination angle distribution is more preferably ±5° or less, and further preferably ±3° or less.

### EXAM PLES

The present invention will be further illustrated by the following examples. It is noted that the following examples are not intended to limit the present invention in any way.

### Example 1

### (1) Preparation of SiC single crystal

A commercially available SiC single crystal substrate (4H-SiC, diameter 100 mm (4 inches), 4° off angle, and 0.35 mm thick) serving as a seed crystal was embedded in a commercially available β-SiC powder (volume-based D50 particle size: 2.3 µm) filled in a container made of carbon. The container was placed in the effective working zone of a resistance furnace (firing furnace) controlled to a temperature range within ±50°C of the preset temperature, and heat-treated at 2450°C for 10 hours in an argon atmosphere to grow a SiC single crystal on the seed crystal.

### (2) Polishing

The surfaces (Si-face and C-face) of the obtained SiC single crystal were polished using diamond abrasive grains, and then finished by chemical mechanical polishing (CMP) to obtain a SiC single crystal substrate.

### (3) Evaluation of SiC single crystal substrate

### (3-1) Measurement of plate warpage

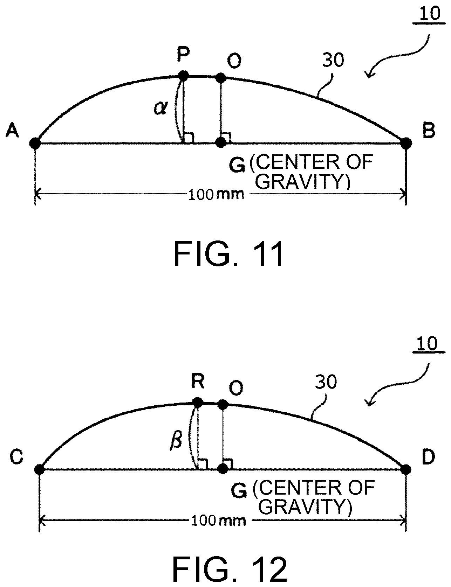

The amount of warpage on the polished surface of the obtained SiC single crystal substrate was measured using a high precision laser measuring device (LT-9010M manufactured by Keyence Corporation). As shown in Figure 10, in a planar view figure of the surface (SiC single crystal 30) of the SiC single crystal substrate 10, two straight lines X and Y that were orthogonal to each other through a point G, which was the center of gravity of the planar view figure, were drawn, and two points A and B each 45 mm away from the point G on the straight line X and two points C and D each 45 mm away from the point G on the straight line Y were defined. Next, as shown in Figure 11, among line segments extending perpendicularly to a line segment AB from any point on a curve AB between the point A and the point B on the surface (SiC single crystal 30) of the SiC single crystal substrate 10, a point P on the curve AB where the distance of the line segment was the longest was determined (for example, in Figure 11, there are points P, O, and the like as arbitrary points on the curve AB, but among the line segments extending from each point perpendicular to the line segment AB, the longest line segment is the line segment extending from the point P). Then, a distance between the line segment AB and the point P was taken to be an amount of warpage α. Further, as shown in Figure 12, among line segments extending perpendicularly to a line segment CD from any point on a curve CD between the point C and the point D on the surface (SiC single crystal 30) of the SiC single crystal substrate 10, a point R on the curve CD where the distance of the line segment was the longest was determined (for example, in Figure 12, there are points R, O, and the like as arbitrary points on the curve CD, but among the line segments extending from each point perpendicular to the line segment CD, the longest line segment is the line segment extending from the point R). Then, a distance between the line segment CD and the point R was taken to be an amount of warpage β. The mean value of these amounts of warpage α and β was taken to be the amount of warpage. The results were as shown in Table 1.

### (3-2) Evaluation of basal plane dislocation density

The SiC single crystal substrate obtained in (2) above was placed in a nickel crucible together with KOH crystals. The crucible was etched in an electric furnace at 500°C for 10 minutes. The etched sample (SiC single crystal substrate) was cleaned, its surface was observed with an optical microscope, and the types of various defects were determined from the shape of the pits. Among these defects, the number of basal plane dislocations was measured, and the basal plane dislocation density (cm⁻²) was calculated by dividing the number of basal plane dislocations by the area (cm²) of the observation region. Specifically, the total number of basal plane dislocations was measured by photographing 100 visual fields of 2.8 mm long × 3.6 mm wide at a magnification of 20 times on any parts of the sample surface, and the basal plane dislocation density was calculated by dividing this total by 10.1 cm², which is the total area of the 100 visual fields. The results were as shown in Table 1.

### Example 2

A SiC single crystal substrate was produced and evaluated in the same manner as in Example 1 except that, in (1) above, the commercially available SiC single crystal substrate serving as the seed crystal was placed on the commercially available β-SiC powder filled in the container made of carbon so that only the Si surface of the seed crystal was in contact with the powder. The amount of warpage and the basal plane dislocation density of the obtained substrate were as shown in Table 1.

### Example 3

A SiC single crystal substrate was produced and evaluated in the same manner as in Example 1 except that, in (1) above, the commercially available SiC single crystal substrate serving as the seed crystal was placed at the bottom of the container made of carbon so that the Si surface of the substrate was facing up, and the commercially available β-SiC powder was filled from above that. The amount of warpage and the basal plane dislocation density of the obtained substrate were as shown in Table 1.

### Example 4

A SiC single crystal substrate was produced and evaluated in the same manner as in Example 1 except that, in (1) above, (i) the commercially available SiC single crystal substrate serving as the seed crystal was placed at the bottom of the container made of carbon so that the Si surface of the substrate was facing up, and the commercially available β-SiC powder was filled from above that, and (ii) a TaC polycrystalline dense body (relative density of 90% or more) was further placed on the top surface of the β-SiC powder layer. The amount of warpage and the basal plane dislocation density of the obtained substrate were as shown in Table 1.

### Example 5

A SiC single crystal substrate was produced and evaluated in the same manner as in Example 1 except that, in (1) above, (i) a TaC polycrystalline dense body (relative density of 90% or more) was placed at the bottom of the container made of carbon, and (ii) the commercially available β-SiC powder was filled from above that, and the commercially available SiC single crystal substrate serving as the seed crystal was further placed above the β-SiC powder layer so that only the Si surface of the substrate was in contact with the powder. The amount of warpage and the basal plane dislocation density of the obtained substrate were as shown in Table 1.

### Example 6

A SiC single crystal substrate was produced and evaluated in the same manner as in Example 1 except that, in (1) above, (i) a TaC polycrystalline dense body (relative density of 90% or more) was placed at the bottom of the container made of carbon, (ii) the commercially available β-SiC powder was filled from above that, then the commercially available SiC single crystal substrate serving as the seed crystal was embedded therein, and (iii) a TaC polycrystalline dense body (relative density of 90% or more) was further placed above the β-SiC powder. The amount of warpage and the basal plane dislocation density of the obtained substrate were as shown in Table 1.

### Example 7

A SiC single crystal substrate was produced and evaluated in the same manner as in Example 1 except that, in (1) above, a ring-shaped TaC polycrystalline dense body (relative density of 90% or more) was placed so as to follow an inner wall of the container made of carbon (that is, a dense body having a relative density of 90% or more was placed on an outer circumferential edge of the SiC powder layer). The amount of warpage and the basal plane dislocation density of the obtained substrate were as shown in Table 1.

### Example 8

A SiC single crystal substrate was produced and evaluated in the same manner as in Example 2 except that, in (1) above, a ring-shaped TaC polycrystalline dense body (relative density of 90% or more) was placed so as to follow an inner wall of the container made of carbon. The amount of warpage and the basal plane dislocation density of the obtained substrate were as shown in Table 1.

### Example 9

A SiC single crystal substrate was produced and evaluated in the same manner as in Example 3 except that, in (1) above, a ring-shaped TaC polycrystalline dense body (relative density of 90% or more) was placed so as to follow an inner wall of the container made of carbon. The amount of warpage and the basal plane dislocation density of the obtained substrate were as shown in Table 1.

### Example 10

A SiC single crystal substrate was produced and evaluated in the same manner as in Example 4 except that, in (1) above, a ring-shaped TaC polycrystalline dense body (relative density of 90% or more) was placed so as to follow an inner wall of the container made of carbon. The amount of warpage and the basal plane dislocation density of the obtained substrate were as shown in Table 1.

### Example 11

A SiC single crystal substrate was produced and evaluated in the same manner as in Example 5 except that, in (1) above, a ring-shaped TaC polycrystalline dense body (relative density of 90% or more) was placed so as to follow an inner wall of the container made of carbon. The amount of warpage and the basal plane dislocation density of the obtained substrate were as shown in Table 1.

### Example 12

A SiC single crystal substrate was produced and evaluated in the same manner as in Example 6 except that, in (1) above, a ring-shaped TaC polycrystalline dense body (relative density of 90% or more) was placed so as to follow an inner wall of the container made of carbon. The amount of warpage and the basal plane dislocation density of the obtained substrate were as shown in Table 1.

### Example 13 (comparison)

A SiC single crystal substrate was produced and evaluated in the same manner as in Example 1 except that, in (1) above, a β-SiC polycrystalline plate produced by thermal CVD was used instead of the β-SiC powder, and the heat-treatment was performed by placing the β-SiC polycrystalline plate in the container made of carbon in a state in which the β-SiC polycrystalline plate was in contact with the Si surface of the commercially available SiC single crystal substrate serving as the seed crystal. The amount of warpage and the basal plane dislocation density of the obtained substrate were as shown in Table 1.

### Example 14 (comparison)

An attempt was made to produce a SiC single crystal substrate in the same manner as in Example 1 except that, in (1) above, the commercially available SiC single crystal substrate serving as the seed crystal was placed on the commercially available β-SiC powder filled in the container made of carbon with a spacer (2 mm) made of carbon interposing so that the seed crystal was not in contact with the β-SiC powder. However, a SiC single crystal did not grow on the seed crystal, and therefore warpage was not measured and evaluation of the basal plane dislocation density was not carried out.

### Example 15 (comparison)

A SiC single crystal substrate was polished and evaluated in the same manner as in Example 1, except that the SiC single crystal was produced as follows. The amount of warpage and the basal plane dislocation density of the obtained substrate were as shown in Table 1.

### (Preparation of SiC single crystal)

In (1) above, a commercially available SiC single crystal substrate serving as a seed crystal was embedded in commercially available β-SiC powder filled in a container made of carbon. The container was placed outside the effective working zone of the resistance furnace, and a SiC single crystal was grown by performing heat treatment at 2450°C for 10 hours in an argon atmosphere with a large temperature gradient exceeding the preset temperature ±50°C.

### [Table 1]

**Table 1**

| | SiC Single Crystal Substrate Production Conditions | | | | | | SiC Single Crystal Substrate Evaluation | |
|---|---|---|---|---|---|---|---|---|
| | Form of SiC raw material | Position of seed crystal relative to SiC powder layer | Temperature gradient during heat treatment | Position of dense body | | | Amount of warpage (µm) | Basal plane dislocation density (cm⁻²) |
| | | | | Top surface of powder layer | Bottom surface of powder layer | Outer circumferential edge of powder layer | | |
| Example 1 | powder | embedded in powder layer | small | - | - | - | 27 | 7.3×10¹ |
| Example 2 | powder | top surface of powder layer | small | - | - | - | 32 | 1.1×10¹ |
| Example 3 | powder | bottom surface of powder layer | small | - | - | - | 33 | 2.8×10¹ |
| Example 4 | powder | bottom surface of powder layer | small | present | - | - | 24 | 5.5×10⁰ |
| Example 5 | powder | top surface of powder layer | small | - | present | - | 21 | 6.7×10⁰ |
| Example 6 | powder | embedded in powder layer | small | present | present | - | 29 | 8.5×10⁰ |
| Example 7 | powder | embedded in powder layer | small | - | - | present | 28 | 5.2×10¹ |
| Example 8 | powder | top surface of powder layer | small | - | - | present | 25 | 4.0×10¹ |
| Example 9 | powder | bottom surface of powder layer | small | - | - | present | 32 | 1.2×10¹ |
| Example 10 | powder | bottom surface of powder layer | small | present | - | present | 11 | 8.4×10⁰ |
| Example 11 | powder | top surface of powder layer | small | - | present | present | 16 | 3.6×10⁰ |
| Example 12 | powder | embedded in powder layer | small | present | present | present | 10 | 2.3×10⁰ |
| Example 13* | bulk body (polycrystal -line plate) | - (in contact with bulk body) | small | - | - | - | 41 | 2.5×10² |
| Example 14* | powder | above powder layer (gap exists via a spacer) | small | - | - | - | - | - |
| Example 15* | powder | embedded in powder layer | large | - | - | - | 73 | 1.1×10² |

| | | | | | | | | |
|---|---|---|---|---|---|---|---|---|
| * Indicates comparative examples. A "small" "temperature gradient" means that the container is placed in the effective working zone of a firing furnace controlled to a temperature range within ±50°C of the preset temperature. | | | | | | | | |

From Examples 1 to 12, although the cause is unknown, it was found that when the heat treatment is performed in a state where the SiC single crystal serving as the seed crystal and the SiC powder layer are in contact with each other and the temperature gradient is small (that is, when the heat treatment is performed with the effective heat treatment controlled within a temperature range of ±50°C of the preset temperature), a SiC single crystal substrate having a low basal plane dislocation density can be obtained. Further, since this SiC single crystal substrate has a small thermal stress, it was found that a SiC single crystal substrate having a small amount of warpage can be obtained. Meanwhile, from Examples 13 to 15 (comparison), it was found that when a SiC polycrystalline plate is used instead of SiC powder or the heat treatment is performed under a large temperature gradient, the amount of warpage of the substrate increases and the basal plane dislocation density also increases. In addition, it was found that when the heat treatment is performed in a state where the SiC single crystal and the SiC powder are not in contact with each other, a SiC single crystal does not grow.

## Claims

1. A method for producing a SiC single crystal substrate comprising the steps of:
placing a SiC single crystal serving as a seed crystal and a SiC powder layer in a container in a state in which the SiC single crystal and the SiC powder layer are in contact with each other; and
performing a heat treatment by placing the container in an effective working zone of a firing furnace controlled to a temperature range within ±50°C of a preset temperature to grow a SiC single crystal on the seed crystal.

2. The method for producing a SiC single crystal substrate according to claim 1, wherein only one side of the seed crystal is in contact with the SiC powder layer.

3. The method for producing a SiC single crystal substrate according to claim 1 or 2, wherein the temperature range is within ±20°C of the preset temperature.

4. The method for producing a SiC single crystal substrate according to any one of claims 1 to 3, wherein the temperature range is within ±10°C of the preset temperature.

5. The method for producing a SiC single crystal substrate according to any one of claims 1 to 4, wherein a dense body having a relative density of 90% or more is placed on a bottom surface and/or top surface of the SiC powder layer (excluding the surface in contact with the seed crystal).

6. The method for producing a SiC single crystal substrate according to any one of claims 1 to 5, wherein a dense body having a relative density of 90% or more is placed on an outer circumferential edge of the SiC powder layer.

7. The method for producing a SiC single crystal substrate according to any one of claims 1 to 4, wherein a dense body having a relative density of 90% or more is placed on a bottom surface and/or top surface of the SiC powder layer (excluding the surface in contact with the seed crystal) and the dense body having a relative density of 90% or more is placed on an outer circumferential edge of the SiC powder layer.

8. The method for producing a SiC single crystal substrate according to any one of claims 5 to 7, wherein the relative density of the dense body is 95% or more.

9. The method for producing a SiC single crystal substrate according to any one of claims 5 to 8, wherein the relative density of the dense body is 99% or more.

10. A SiC single crystal substrate having a basal plane dislocation density of at least one surface of 0 to 1.0 × 10² cm⁻² and an amount of warpage of 0 to 40 µm, wherein
in a planar view figure of a surface of the SiC single crystal substrate, when two straight lines X and Y that are orthogonal to each other through a point G, which is the center of gravity of the planar view figure, are drawn, with two points A and B being defined to be each 45 mm away from the point G on the straight line X and two points C and D being defined to be each 45 mm away from the point G on the straight line Y,
the amount of warpage is defined by:
(i) determining, among line segments extending perpendicularly to a line segment AB from any point on a curve AB between the point A and the point B on the surface of the SiC single crystal substrate, a point P on the curve AB where the distance of the line segment is the longest,
(ii) taking a distance between the line segment AB and the point P to be an amount of warpage α,
(iii) determining, among line segments extending perpendicularly to a line segment CD from any point on a curve CD between the point C and the point D on the surface of the SiC single crystal substrate, a point R on the curve CD where the distance of the line segment is the longest,
(iv) taking a distance between the line segment CD and the point R to be an amount of warpage β, and
(v) taking an arithmetic mean value of the amounts of warpage α and β to be the amount of warpage.
